(19) Europäisches Patentamt
European Patent Office
Office européen des brevets

(11) Veröffentlichungsnummer: **0 014 237**
**B1**

(12) **EUROPÄISCHE PATENTSCHRIFT**

(45) Veröffentlichungstag der Patentschrift: **20.04.83**

(21) Anmeldenummer: **79104589.1**

(22) Anmeldetag: **19.11.79**

(51) Int. Cl.³: **G 03 C 1/68,**
C 08 F 283/10, C 08 F 2/50,
C 08 G 59/16

(54) **Strahlungsempfindliche Überzugszusammensetzung und deren Verwendung zur Herstellung eines negativen Resistbildes.**

(30) Priorität: **08.12.78 US 967742**

(43) Veröffentlichungstag der Anmeldung:
**20.08.80 Patentblatt 80/17**

(45) Bekanntmachung des Hinweises auf die Patenterteilung:
**20.04.83 Patentblatt 83/16**

(84) Benannte Vertragsstaaten:
**DE FR GB**

(56) Entgegenhaltungen:
**DE - A - 2 207 853**
**DE - A - 2 459 179**
**FR - A - 2 126 833**
**NL - A - 7 207 743**
**US - A - 3 301 743**

(73) Patentinhaber: **International Business Machines Corporation**
**Armonk, N.Y. 10504 (US)**

(72) Erfinder: **Skarvinko, Eugene A.**
**4 Giles Street**
**Binghamton, New York 13905 (US)**

(74) Vertreter: **Kreidler, Eva-Maria, Dr. rer. nat.**
**Schönaicher Strasse 220**
**D-7030 Böblingen (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Courier Press, Leamington Spa, England.

EP 0 014 237 B1

# Strahlungsempfindliche Überzugszusammensetzung und deren Verwendung zur Herstellung eines negativen Resistbildes.

Die Erfindung betrifft eine strahlungsempfindliche Überzugszusammensetzung mit einem Gehalt an einer polyäthylenisch ungesättigten Verbindung, einem Photoinitiator, gegebenenfalls einem Härtungsmittel und einem Verdünnungsmittel. Die Zusammensetzung enthält ein Vorreaktionsprodukt eines Epoxidpolymeren, welches wenigstens sechs Epoxidgruppen aufweist mit einer monoäthylenisch ungesättigten Carbonsäure. Diejenigen Teile der erfindungsgemäßen Zusammensetzung, die ultraviolettem Licht ausgesetzt werden, werden gehärtet.

Die Bereitstellung von Überzugszusammensetzungen, welche brauchbare Eigenschaften zur Bilderzeugung (Auflösung und Bildschärfe) aufweisen, damit sie zur Bilderzeugung oder zur Herstellung einer Maske, insbesondere für integrierte Schaltkreise, geeignet sind und die gleichzeitig die notwendigen physikalischen Eigenschaften für einen bleibenden Schutzüberzug haben, ist sehr schwierig. Im einzelnen müssen die Zusammensetzungen, die zu einem Schutzüberzug in Form eines Musters für eine Schaltkreisplatte geeignet sind, eine Vielzahl verschiedener Eigenschaften aufweisen. In vielen Fällen ist in Abhängigkeit von der spezifischen Verwendung und/oder den Bedingungen der Umgebung und in Abhängigkeit von den gesetzten Prioritäten ein Kompromiß zwischen diesen Eigenschaften erforderlich. In einem speziellen Fall wird eine Eigenschaft in einem zufriedenstellenden Grad bei gleichzeitiger Abnahme einer anderen Eigenschaft erreicht. Bei vielen Überzügen werden beispielsweise die filmbildenden Eigenschaften geopfert, um zufriedenstellende Auflösung und Bildschärfe zu erhalten; und andererseits wurde, wenn es möglich war, die Bildschärfe geopfert, um die gewünschten filmbildenden Eigenschaften zu erhalten.

Bei der Herstellung integrierter Schaltkreisplatten ist es erwünscht, in dem zur Anwendung kommenden Polymermaterial mittels eines photolytischen Prozesses ein Muster herzustellen, wie das für Photoresistmaterialien üblich ist, wobei dieses Muster, anders als bei einem Photoresist, zusätzlich eine oder mehrere Funktionen während oder nach der Herstellung der gedruckten Schaltkreisplatte übernehmen kann. Aufgrund der einmaligen Kombination guter Eigenschaften, die durch die Zusammensetzungen der vorliegenden Erfindung erhalten werden, ist es möglich, die Überzugszusammensetzung zur Herstellung einer permanent verbleibenden Ätzmaske, einer Lötmaske, einer Metallabscheidemaske, eines dielektrischen Films oder eines Schutzüberzugs zu verwenden.

Gemäß der vorliegenden Erfindung wurde gefunden, daß spezielle Reaktionsprodukte einer monoäthylenisch ungesättigten Carbonsäure mit bestimmten Epoxiden in bestimmten relativen Mengen in Kombination mit anderen Bestandteilen der Zusammensetzung photoprozessierbare Überzüge ergeben, die nicht nur eine gute Auflösung (d.h., scharf definierte Bilder), sondern auch ausgezeichnete filmbildende Eigenschaften sowie gute Flexibilität und Zähigkeit aufweisen.

Ein bestimmtes Problem, das bei bestimmten, bisher bekannten, photoprozessierbaren Epoxidharzüberzügen bei deren Verwendung für die Herstellung integrierter Schaltkreise auftrat, betraf die Ausbildung eines Zackenmusters, das auf Leiterzügen integrierter Schaltkreise nach deren Herstellung zu beobachten war. Der Ausdruck "Zackenbildung" beschreibt die Anwesentheit von Unebenheiten oder Wellen auf der Oberfläche von Schaltkreisleiterzügen, die wahrscheinlich auf ein übermäßiges Schrumpfen des Überzugs während des Entwickelns (Anwendung eines Lösungsmittels zur Entfernung nichtbelichteter Polymerbereiche) zurückzuführen war. In extremen Fällen trat eine Rißbildung in den Überzügen auf, wodurch metallische Leiterzüge freigelegt wurden.

Aufgabe der Erfindung ist die Bereitstellung einer Überzugszusammensetzung mit Eigenschaften, die deren gleichzeitige Verwendung als Photoresist und als Schutzüberzug auf integrierten Schaltkreisplatten gestatten und mit der das Problem der Zackenbildung eliminiert werden kann. Die Überzugszusammensetzung weist einen minimalen Verlust an Schichtdicke nach dem Entwickeln und Härten auf.

Die Aufgabe der Erfindung wird gelöst durch die Erfindung, wie sie in den Ansprüchen gekennzeichnet ist. Die Erfindung umfaßt auch die Verwendung der Überzugszusammensetzung zur Herstellung eines negativen Resistbildes auf einer Schaltkreisplatte. Vorteilhafte Ausführungsformen der Erfindung sind in den Unteransprüchen niedergelegt. Mit der Erfindung werden die zuvor angegebenen Vorteile erhalten.

Die Erfindung wird anhand der speziellen Beschreibung und der Ausführungsbeispiele näher erläutert.

Es sind bereits bestimmte Expoxidharzzusammensetzungen als strahlungsempfindliche Resistmaterialien beschrieben worden. So wurde beispielsweise die Verwendung bestimmter Reaktionsprodukte einer monoäthylenisch ungesättigten Säure und bestimmter Epoxide für die Herstellung von Mustern, wie gedruckten elektronischen Schaltkreisen in der deutschen Patentschrift 24 59 179 beschrieben, und in der europäischen Patentanmeldung 3040 (78 101 833.8) ist eine strahlungsempfindliche Überzugsmasse und deren Verwendung als negativer Resist beschrieben.

In der deutschen Patentschrift 24 59 179 ist eine strahlungsempfindliche Überzugszusammensetzung beschrieben, welche sich von der vorliegenden Erfindung dahingehend unterscheidet, daß die verwendete Menge an Acrylsäure viel niedriger ist als in der vorliegenden Erfindung. In dieser Patentschrift ist kein Hinweis gegeben, daß durch eine beachtliche Erhöhung der Menge an Acrylsäure das

problem der Zackenbildung vermieden werden kann, oder daß die anderen Vorteile gemäß der vorliegenden Erfindung erhalten werden können. In den Zusammensetzungen der vorliegenden Erfindung ist auch der Einsatz des primären aromatischen Amins, das in den Beispielen der deutschen Patentschrift 24 59 179 verwendet wird, nicht erforderlich. Gemäß der vorliegenden Erfindung werden Zusammensetzungen bereitgestellt, die keine primären Amine dieser Art enthalten, weil diese krebserzeugend sind. Gemäß der vorliegenden Erfindung wird auch vorzugsweise ein anderer Entwickler als Trichloräthylen verwendet, der für die Zusammensetzungen der Ausführungsbeispiele der deutschen Patentschrift verwendet wurde. Dies ist vorteilhaft, weil Trichloräthylen auch als krebserzeugendes Material betrachtet wird.

Weiterhin ist in den Zusammensetzungen der vorliegenden Erfindung die Verwendung von Kohlenstofftetrabromid also Initiator, der in der handelsüblichen Version der Zusammensetzungen des zuvor angegebenen Patents verwendet wird, nicht erforderlich. Ein weiterer Vorteil der vorliegenden Erfindung, verglichen mit der handelsüblichen Version der Zusammensetzungen der deutschen Patentschrift 24 59 179 ist, daß der Verlust an Filmdicke nach dem Entwickeln und Härten stark herabgesetzt ist.

Die europäische Patentanmeldung 3040 betrifft die vorliegende Erfindung auch nicht, weil die Erfindung, die dort beschrieben wird, eine Mischung bestimmter Epoxide betrifft, die sich stark von dem Typ der polyfunktionellen Polymeren der vorliegenden Erfindung unterscheiden. In der Tat führt die europäische Patentanmeldung 3040 den Fachmann von der vorliegenden Erfindung weg. So ist beispielsweise auf den Seiten 7 und 8 dieser Patentanmeldung angegeben, daß die Verwendung eines Epoxids des Typs, der in der vorliegenden Erfindung anstelle der Epoxide gemäß der europäischen Patentanmeldung 3040 eingesetzt wird, in der dort beschriebenen Erfindung keine zufriedenstellenden Resultate ergab. Die Versuche, die gemäß der europäischen Patentanmeldung 3040 und entsprechend der Offenbarung der deutschen Patentschrift 24 59 179 tatsächlich durchgeführt wurden, erforderten die Verwendung von wesentlich weniger Säure als in der vorliegenden Erfindung.

Andere Vorschläge bezüglich der Verwendung bestimmter Reaktionsprodukte monoäthylenisch ungesättigter Säuren und bestimmter Epoxide zur Herstellung von Mustern sind in den US—Patentschriften 3 661,576 und 3 988 610 beschrieben.

Aus der deutschen Offenlegungsschrift 2 207 853 sind photoempfindliche dielektrische Zusammensetzungen bekannt, die ein mehrfunctionelles Vinylmonomersystem, einen latenten Photosensibilisator, ein vernetzbares vorgehärtetes Epoxidharz oder Epoxid-Novolak-Harz, ein Härtungsmittel und ein inertes Lösungsmittel für alle Bestandteile enthalten.

Die dort beschriebene Zusammensetzung unterscheidet sich hinsichtlich des Epoxidharzanteils und der Mengenverhältnisse von der Zusammensetzung der vorliegenden Erfindung.

Aus der französischen Offenlegungsschrift 2 126 833 sind Reaktionsprodukte aus einem Epoxid mit einer oder mehreren Epoxidgruppen je Molekül und einer ungesättigten Monocarbonsäure und einem gesättigten oder ungesättigten Alkydharz mit endständigen Carboxylgruppen bekannt mit einem Verhältnis der Carboxylgruppen zu den Epoxidgruppen zwischen 0,2 und 2,0:1, vorzugsweise zwischen 0,4 und 1,8:1. Es handelt sich bei diesem System um ein anderes hinsichtlich der einzelnen Epoxidharz- und Alkydharz-Bestandteile als in der vorliegenden Anmeldung. Die Zusammensetzungen sind nicht zur Herstellung von Mustern in der Technologie integrierter Schaltkreise geeignet.

Es wurden auch verschiedene Uberzugszusammensetzungen mit einem Gehalt an monoäthylenisch ungesättigten Säure-Epoxid-Addukten zum Beschichten beschrieben, bei denen jedoch die Probleme der Auflösung, die für die Verwendung einer Zusammensetzung als lichtempfindlicher Resist zur Herstellung von Mustern, wie integrierten Schaltkreisen, wesentlich sind, keine Rolle spielen. Beispiele für solche Überzugszusammensetzungen sind in den US—Patentschriften 3 912 670, 3 772 062, 3 450 613, 4 003 877 und 4 014 771 beschrieben.

Des weiteren wurde die Verwendung einer lichtempfindlichen Zusammensetzung auf der Basis von Epoxidharzen, bei denen keine Vorreaktion mit einer monoäthylenisch ungesättigten Säure stattfindet, die aber bestimmte spezifische Typen von Sensibilisatoren enthalten muß, für die Herstellung selektiver oder gemusterter Überzüge beschrieben. Ein Beispiel ist in der US—Patentschrift 3 930 856 beschrieben.

Es wurden auch bereits Zusammensetzungen, welche nicht lichtempfindlich sind, aber welche monoäthylenisch ungesättigte Säure-Epoxidaddukte enthalten, beschrieben. Beispiele dieser Art sind in den US—Patentschriften 3 301 743 und 3 373 075 beschrieben. Weiterer Stand der Technik, welcher die Reaktionen von äthylenisch ungesättigten Säuren und verschiedenen Epoxidharzen betrifft, ist in den britischen Patentschriften 717 708 und 794 572; in den US—Patentschriften 3 637 618, 3 804 735, 3 840 448, 3 847 770 und 3 968 016 abgehandelt.

Die vorliegende Erfindung betrifft eine Überzugszusammensetzung, in der durch Belichten ein Muster hergestellt werden kann. Die Zusammensetzung enthält das Reaktionsprodukt wenigstens eines epoxidierten nichtlinearen Novolaks mit mindestens sechs Epoxidgruppen mit wenigstens einer monoäthylenisch ungesättigten Carbonsäure. Die Carbonsäure oder Säuren werden in einer Menge von wenigstens 0,9 Mol pro Epoxidäquivalentgewicht des epoxidierten Novolaks eingesetzt. Die Zusammensetzung enthält auch wenigstens eine polyäthylensich ungesättigte Verbindung und wenigstens einen Photoinitiator.

Die Erfindung betrifft auch Unterlagen, die mit der zuvor angegebenen Zusammensetzung beschichtet sind.

Die Erfindung betrifft auch die Verwendung der Zusammensetzung zur Herstellung eines negativen Resistbildes. Dieses Verfahren umfaßt das Belichten einer Schicht der oben angegebenen Zusammensetzung mit ultraviolettem Licht in einem vorherbestimmten Muster. Die Belichtung wird so lange durchgeführt, bis in den belichteten Bereichen der Schicht eine wesentliche Härtung stattgefunden hat. Diejenigen Teile der Schicht, welche nicht mit ultraviolettem Licht belichtet wurden, werden entfernt.

Gemäß der vorliegenden Erfindung werden spezielle Reaktionsprodukte wenigstens einer $\alpha,\beta$-äthylenisch ungesättigten Carbonsäure mit wenigstens einem epoxidierten nichtlinearen Novolak, welcher wenigstens etwa sechs endständige Epoxidgruppen aufweist, angewendet. Was die $\alpha,\beta$-äthylenisch ungesättigten Carbonsäuren anbetrifft, so sind diese bekannt und im Handel leicht erhältlich. Beispiele solcher Säuren sind Acrylsäure, Methacrylsäure und Crotonsäure. Die am meisten bevorzugte äthylenisch ungesättigte Carbonsäure, welche erfindungsgemäß verwendet wird, ist Acrylsäure.

Der epoxidierte Novolak, der erfindungsgemäß verwendet wird, muß nichtlinear sein, d.h. aus einer hochverzweigten Kette bestehen und muß wenigstens etwa sechs endständige Epoxidgruppen und vorzugsweise etwa acht endständige Epoxidgruppen enthalten. Epoxidierte Novolakpolymere sind im Handel erhältlich und können nach bekannten Herstellungsverfahren durch Reaktion eines thermoplastischen Phenolaldehyds eines mehrkernigen zweiwertigen Phenols mit einem Halo-epoxidalkan hergestellt werden.

Das mehrkernige zweiwertige Phenol kann folgende Formel aufweisen:

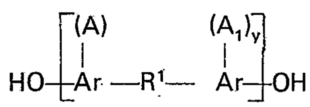

in der Ar ein aromatischer zweiwertiger Kohlenwasserstoff wie Naphthalin und vorzugsweise Phenylen ist; A und $A_1$, welche gleich oder verschieden sein können, sind Alkylreste, vorzugsweise mit 1 bis 4 Kohlenstoffatomen, Halogene, wie Flour, Chlor, Brom und Jod oder Alkoxyradikale, vorzugsweise mit 1 bis 4 Kohlenstoffatomen; x und y sind ganze Zahlen von 0 bis zu einem Maximalwert, der der Anzahl der Wasserstoffatome am aromatischen Rest (Ar) entspricht, die durch Substituenten ersetzt werden können und $R^1$ ist ein Bindeglied zwischen zwei benachbarten Kohlenstoffatomen wie in Dihydroxydiphenyl oder ein zweiwertiger Rest, beispielsweise

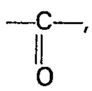 , —O—, —S—, —SO—, $—SO_2—$ und —S—S—

oder zweiwertige Kohlenwasserstoffreste wie Alkylen-, Alkyliden-, cycloaliphatische, d.h., Cycloalkylen- und Cycloalkylidenreste; halogenierte, mit Alkoxy- oder Aryloxy-Resten substituierte Alkylen-, Alkyliden- und cycloaliphatische Reste; wie auch Alkarylen- und aromatische Reste, einschließlich halogenierter, mit Alkyl-, Alkoxy- oder Aryloxy-Resten substituierter aromatischer Reste oder ein Ring, der an eine Arylgruppe angegliedert ist; oder $R^1$ kann Polyalkoxy oder Polysiloxy sein oder aus zwei oder mehr Alkyliden-Resten bestehen, die durch einen aromatischen Ring, eine tertiäre Aminogruppe, eine Ätherbindung, eine Carbonylgruppe oder eine schwefelhaltige Gruppe wie Sulfoxid und dgl. getrennt sind.

Beispiele spezifischer zweiwertiger mehrkerniger Phenole schließen u.a. folgende Verbindungen ein: Bis - (hydroxyphenyl)alkane wie 2,2 - Bis - (4 - hydroxyphenol)propan, 2,4' - Dihydroxydiphenylmethan, Bis - (2 - hydroxyphenyl) - methan, Bis - (4 - hydroxyphenyl)methan, Bis(4 - hydroxy - 2,6 - dimethyl - 3 - methoxyphenyl)methan, 1,1 - Bis - (4 - hydroxyphenyl)äthan, 1,2 - Bis - (4 - hydroxyphenyl)äthan, 1,1 - Bis - (4 - hydroxy - 2 - chlorphenyl)äthan, 1,1 - Bis(3 - methyl - 4 - hydroxyphenyl)äthan, 1,3 - Bis - (3 - methyl - 4 - hydroxyphenyl)propan, 2,2 - Bis - (3 - phenyl - 4 - hydroxyphenyl)propan, 2,2 - Bis - (3 - isopropyl - 4 - hydroxyphenyl) - propan, 2,2 - Bis(2 - isopropyl - 4 - hydroxyphenyl)propan, 2,2 - Bis(4 - hydroxynaphthyl)propan, 2,2 - Bis - (4 - hydroxyphenyl)pentan, 3,3 - Bis - (4 - hydroxyphenyl)pentan, 2,2 - Bis - (4 - hydroxyphenyl)heptan, Bis - (4 - hydroxyphenyl)phenylmethan, Bis - (4 - hydroxyphenyl)cyclohexylmethan, 1,2 - Bis - (4 - hydroxyphenyl) - 1,2 - bis - (phenyl)propan und 2,2 - Bis - (4 - hydroxyphenyl) - 1 - phenyl - propan; Di(hydroxyphenyl)sulfone wie Bis - (4 - hydroxyphenyl)sulfon, 2,4' - Dihydroxydiphenyl - sulfon, 5' - Chlor - 2,4' - dihydroxydiphenylsulfon und 5' - Chlor - 4,4' - dihydroxydiphenyl - sulfon; Di(hydroxyphenyl)äther wie Bis - (4 - hydroxyphenyl)äther, die 4,3'-, 4,2'-, 2,2'-, 2,3'-Dihydroxydiphenyläther, 4,4' - Dihydroxy - 2,6 - dimethyldiphenyläther, Bis - (4 - hydroxy - 3 - isobutylphenyl)äther, Bis - (4 - hydroxy - 3 - isopropylphenyl)äther, Bis - (4 - hydroxy - 3 - chlorphenyl)äther, Bis - (4 - hydroxy - 3 - fluorphenyl)äther, Bis - (4 - hydroxy - 3 - bromphenyl)äther, Bis - (4 - hydroxynaphthyl)äther, Bis - (4 - hydroxy - 3 - chlornaphthyl)äther,

Bis - (2 - hydroxydiphenyl)ather, 4,4' - Dihydroxy - 2,6 - dimethoxydiphenyläther und 4,4' - Dihydroxy - 2,5 - diäthoxydiphenyläther.

Die bervorzugten zweiwertigen mehrkernigen Phenole werden dargestellt durch die allgemeine Formel:

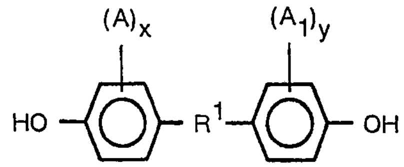

in der A und $A_1$ die zuvor angegebene Bedeutung besitzen, x und y Werte von 0 bis 4 aufweisen und $R^1$ ein zweiwertiger gesättiger aliphatischer Kohlenwasserstoffrest ist, insbesondere Alkylen- und Alkylidenreste mit 1 bis 3 Kohlenstoffatomen und Cycloalkylenreste mit bis zu 10 Kohlenstoffatomen. Das am meisten bevorzugte zweiwertige Phenol ist Bisphenol A, d.h., 2,2-Bis(p-hydroxyphenyl)propan.

Als Kondensationsmittel kann jeder Aldehyd verwendet werden, der mit dem speziellen Phenol kondensiert, beispielsweise Formaldehyd, Acetaldehyd, Propionaldehyd, Butyraldehyd, Heptaldehyd, Cyclohexanon, Methylcyclohexanon, Cyclopentanon, Benzaldehyd und am Kern alkylsubstituierte Benzaldehyde, wie Tolylaldehyd, Naphthaldehyd, Furfurylaldehyd, Glyoxal, Acrolein, oder Verbindungen, die Aldehyde in Freiheit setzen können, wie Paraformaldehyd und Hexamethylentetramin. Die Aldehyde können auch in Form einer Lösung, beispielsweise in Form der im Handel erhältlichen Formalinlösung verwendet werden. Formaldehyd wird als Aldehyd bevorzugt.

Die Halo-epoxidalkane können dargestellt werden durch die allgemeine Formel:

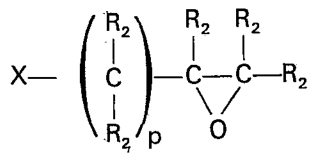

in der X ein Halogenatom (Chlor, Brom, und dgl.) ist, p eine Zahl von 1 bis 8, $R_2$ jeweils Wasserstoff oder eine Alkylgruppe mit bis zu 7 Kohlenstoffatomen; wobei die Anzahl der Kohlenstoffatome in jeder Epoxidalkylgruppe die Gesamtzahl von 10 nicht überschreitet.

Während Glycidyläther, die sich vom Epichlorhydrin ableiten, zur Durchführung der Erfindung besonders bevorzugt werden, sind auch Epoxidpolymere, die Epoxidalkoxygruppen mit einer größeren Anzahl von Kohlenstoffatomen enthalten, geeignet. Diese werden hergestellt, indem man Epichlorhydrin durch die entsprechenden Chloride oder Bromide der Monohydroxyepoxidalkane, wie 1 - Chlor - 2 - methyl - 2,3 - epoxidpropan, 1 - Brom - 2,3 - epoxidpentan, 2 - Chlormethyl - 1,2 - epoxidbutan, 1 - Brom - 4 - methyl - 3,4 - epoxidpentan, 1 - Brom - 4 - äthyl - 2,3 - epoxidpentan, 4 - Chlor - 2 - methyl - 2,3 - epoxidpentan, 1 - Chlor - 2,3 - epoxidoctan, 1 - Chlor - 2 - methyl - 2,3 - epoxidoctan oder 1 - Chlor - 2,3 - epoxiddecan ersetzt. Obgleich es möglich ist, Halo-epoxidalkane mit einer größeren Zahl von Kohlenstoffatomen als die oben angegebene zur verwenden, werden im allgemeinen keine besonderen Vorteil durch die Verwendung von Verbindungen mit einer Gesamtzahl von mehr als 10 Kohlenstoffatomen erzielt.

Die bevorzugten epoxidierten Novolake, die erfindungsgemäß verwendet werden, können durch die nachfolgende mittlere Formel dargestellt werden:

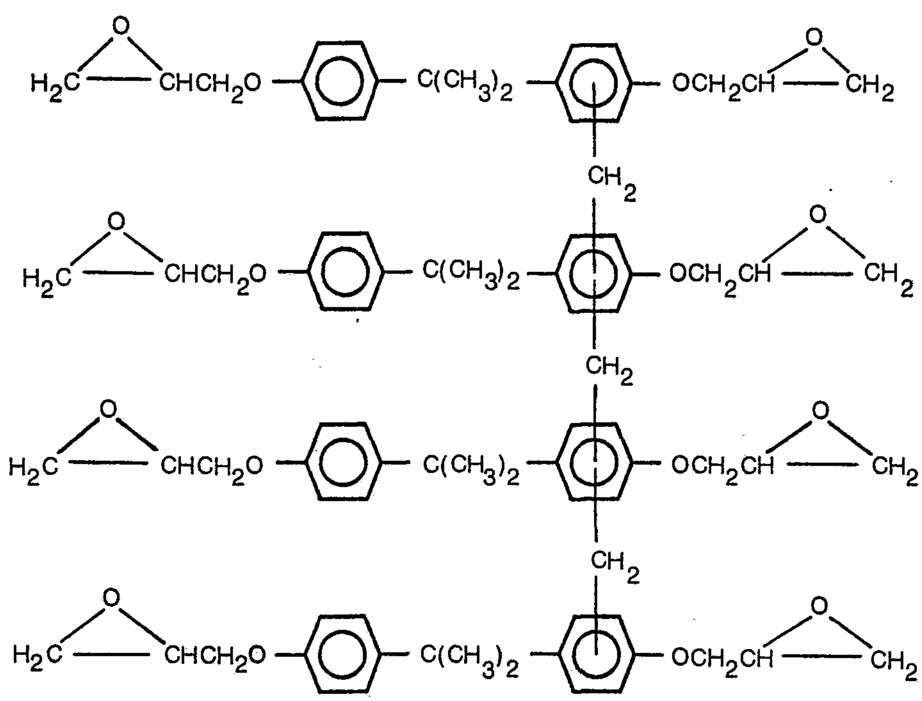

Ein Novalakharz dieser Art ist beispielsweise im Handel unter dem Warenzeichen EPI—REZ SU8 der Celanese Chemical Co erhältlich.

Für die Durchführung und den Erfolg der vorliegenden Erfindung ist wesentlich, daß die monoäthylenisch ungesättigte Carbonsäure oder Carbonsäuren in Mengen von wenigstens 0,9 Mol pro Epoxidäquivalentgewicht des epoxidierten Novolaks an den Novolak gebunden verwendet werden. Das Epoxidäquivalentgewicht wird definiert als das Gewicht des Polymeren in Gramm, welches 1 Grammäquivalent Epoxid enthält. Die Anwendung von Carbonsäure in niedrigeren Mengen, beispielsweise in einer Menge von nur etwa 0,5 Mol pro Epoxidäquivalentgewicht führte zu einem Aushärten oder Abbinden des Polymeren, ehe es als Überzug verwendet werden konnte.

Die Monocarbonsäure wird im allgemeinen in Mengen von 0,9 bis 2 Mol, und vorzugsweise in einer Menge von wenigstens 1 Mol pro Epoxidäquivalentgewicht des epoxidierten Novolaks angewendet. Am meisten bevorzugt sind Monocarbonsäuremengen in der Größenordnung von etwa 1 bis 1,2 Mol pro Epoxidäquivalentgewicht des epoxidierten Novolaks.

Die Bedingungen für die Umsetzung des Epoxids und der Carbonsäure sind bekannt und brauchen im Detail nicht beschrieben zu werden. Es sind beispielsweise Temperaturen von Zimmertemperatur bis etwa 85°C geeignet. Reaktionszeiten bis zu 1 Stunde und von etwa 1 Stunde wurden als ausreichend gefunden. Im allgemeinen wird Atmosphärendruck angewendet. Wenn es gewünscht wird, können auch höhere oder niedrigere Drucke angewendet werden.

Die polyäthylenisch ungesättigten Verbindungen, die in den erfindungsgemäßen Zusammensetzungen verwendet werden, müssen bei Einwirkung von ultraviolettem Licht reagieren und sollten endständige äthylenisch ungesättigte Gruppen enthalten. Sie werden in Mengen angewendet, die ausreichend sind, um die Zusammensetzungen in dem gewünschten Grad lichtempfindlich zu machen. Verbindungen dieser Art schließen ungesättigte Ester von Polyolen und insbesondere Ester von Methylencarbonsäuren ein, wie Athylendiacrylat; Diäthylenglykoldiacrylat; Glycerindiacrylat; Glycerintriacrylat; Athylendimethacrylat; 1,3-Propylendimethacrylat; 1,2,4-Butantriol-trimethacrylat; 1,4-Dihydroxybenzol-dimethacrylat; Pentaerythrit-tetramethacrylat; 1,3-Propandiol-diacrylat; 1,6-Hexandiol-diacrylat; die Bis-acrylate und Methacrylate von Polyäthylenglykolen mit Molekulargewichten von 200 bis 500; Trimethylolpropan-triacrylat; Pentaerythrit-triacrylat; ungesättigte Amide wie diejenigen von Methylencarbonsäuren und insbesondere von $\alpha,\Omega$-Diaminen und von mit Sauerstoff unterbrochenen $\Omega$-Diaminen wie Methylenbisacryl-und Bismethacrylamid; Diäthylentriamin; Tris-methacrylamid; Bis-(methacrylamidopropoxy)äthan; Bis-methacylamidoäthylmethacrylat; N-[($\beta$-hydroxyäthyloxy)äthyl]-acrylamid; Vinylester wie Divinylsuccinat, Divinyladipat, Divinylphthalat, Divinylbenzol-1,3-disulfonat und Divinylbutan-1,4-disulfonat und ungesättigte Aldehyde wie Sorbaldehyd.

Die bevorzugten polyäthylenisch ungesättigten Verbindungen schließen Polyäthylenglykol-diacrylate und Trimethylolpropan-tri-acrylate ein. Die relativen Mengen der polyäthylenisch ungesättigten Verbindung, die erfindungsgemäß verwendet werden, liegen zwischen 0,5 bis 40%, bzw. zwischen 1 und 20% und vorzugsweise bei 3 Gew.%.

Die bisher bekannten Zusammensetzungen, in denen Carbonsäurereaktionsprodukte der Epoxidtypen der vorliegenden Erfindung verwendet wurden (beispielsweise diejenigen, die in der deutschen

Patentschrift 24 59 179 beschrieben sind), erforderten Mengen an polyäthylenisch ungesättigten Verbindungen in der Größenordnung von 1% oder weniger, um die Zackenbildung auf einem Minimum zu halten. Durch die Anwendung dieser kleinen Mengen der polyäthylenisch ungesättigten Verbindungen wird jedoch die Lichtempfindlichkeit der Zusammensetzungen begrenzt. Durch die vorliegende Erfindung ist es möglich, größere Mengen polyâthylenisch ungesättigter Verbindungen anzuwenden, ohne daß das Problem der Zackenbildung beobachtet wird.

Die Zusammensetzungen der vorliegenden Erfindung enthalten weiterhin einen Photoinitiator oder Sensibilisator. Viele dieser Materialien sind bekannt. Beispiele geeigneter Photoinitiatoren schließen Anthrachinon und substituierte Anthrachinone wie alkyl- oder halogensubstituierte Anthrachinone, beispiesweise 2-tert-Butylanthrachinon, 1-Chloranthrachinon, p-Chloranthrachinon, 2-Methylanthrachinon, 2-Äthylanthrachinon und Octamethylanthrachinon; andere substituierte und nichtsubstituierte mehrkernige Chinone, einschließlich 1,4-Naphthochinon, 9,10-Phenanthrenchinon, 1,2-Benzanthrachinon, 2,3-Benzanthrachinon, 2-Methyl-1,4-naphthochinon, 2,3-Dichlornaphthochinon, 1,4-Dimethylanthrachinon, 2,3-Dimethylanthrachinon, 2-Phenylanthrachinon, 2,3-Diphenylanthrachinon, 3-Chlor-2-methylanthrachinon, Retenchinon, 7,8,9,10-Tetrahydro-naphthacenchinon und 1,2,3,4-Tetrahydrobenzanthracen-7,12-dion ein.

Andere geeignete Photosensibilisatoren schließen Sensibilisatoren vom Halogentyp wie Kohlenstofftetrachlorid, Bromoform und Kohlenstofftetrabromid ein. Weiterhin sind geeignet: Benztriazol, Benzoin, Chloranil, Benzil, Diacetyl, 5-Nitro-salicylaldehyd, 2,4-Dinitrotoluol. Wenn es gewünscht wird, können auch Mischungen von Photoinitiatoren verwendet werden. Bevorzugte Photoinitiatoren gemäß der Erfindung sind Benztriazol und die Anthrachinone, beispielsweise tert-Butylanthrachinon. Der Photoinitiator wird in Mengen angewendet, die ausreichend sind, um die Zusammensetzung für ultraviolettes Licht zu sensibilisieren. Diese liegen im allgemeinen zwischen 0,1 und 10% und vorzugsweise zwischen 0,1 und etwa 5 Gew.-%. In einem bevorzugten Ausführungsbeispiel werden etwa 1 bis 5 Gew.% tert-Butylanthrachinon zusammen mit etwa 0,05 bis 0,5 Gew.% Benztriazol angewendet.

Aus Kostengründen wird am meisten bevorzugt, wenn die Zusammensetzungen der vorliegenden Erfindung keine anorganischen bromhaltigen Sensibilisatoren, wie Bromoform oder Kohlenstofftetrabromid enthalten. Durch die Abwesenheit von Kohlenstofftetrabromid können die Kosten der Zusammensetzung beispielsweise um 50% reduziert werden.

Wenn es gewünscht wird, können die Zusammensetzungen zur Vereinfachung des Auftragens ein organisches nitchtreaktives Verdünnungsmittel enthalten. Beispiele geeigneter Lösungsmittel schließen Trichloräthylen, Athylenglykolätheracetat, Methyldiglykol, Butyldiglykol, Methylenchlorid und Ketone wie Aceton und Methyläthylketon ein. Wenn eines dieser Verdünnungsmittel verwendet wird, wird es in einer Menge verwendet, daß die Zusammensetzungen in Abhängigkeit von ihrer Anwendung eine Viskosität von 3 bis 250 $\times$ $10^{-5}$ $m^2/s$ aufweisen. Für Sprühverfahren werden beispielsweise Viskositäten von 3 bis 20 $\times$ $10^{-5}$ $m^2/s$ angewendet, und das Aufspinnen erfolgt im allgemeinen unter Anwendung von Viskositäten von 8 bis 10 $\times$ $10^{-5}$ $m^2/s$.

Wenn es gewünscht wird, können die Zusammensetzungen auch Hilfsmittel wie zusätzliche Härter für die Nachhärtung (beispielsweise Phenylimidazol) enthalten.

Die Zusammensetzungen der vorliegenden Erfindung können hergestellt werden, indem man zuerst eine Lösung des Epoxidpolymeren herstellt und dann die Monocarbonsäure, zusammen mit einem Promotor oder Mischungen von Promotoren wie einem primären, sekundären oder tertiären Amin, beispielsweise Benzyldimethylamin, Triäthylamin oder Triäthanolamin; oder einem Metallsalz wie Zinn(II)octoat oder Eisen(II)octoat, die die Reaktion der Carbonsäuregruppe der Säure mit den endständigen Epoxidgruppen des Epoxidpolymeren begünstigen, zufügt.

Die bevorzugten Promotoren, die verwendet werden, sind die tertiären Amine wie Benzyldimethylamin. In einer bevorzugten Ausführungsform der Erfindung enthält die Zusammensetzung keine primären aromatischen Amine wie Methylendianilin, welches möglicherweise eine krebserzeugende Substanz ist. Primäre Amine dieser Art werden jedoch in den Zusammensetzungen, die in der deutschen Patentschrift 24 59 179 beschrieben sind, zum Erhalt einer brauchbaren Lichtempfindlichkeit verwendet.

Nach der Zumischung und der Reaktion der Säure mit dem Epoxidharz werden im allgemeinen die anderen Bestandteile, die polyäthylenisch ungesättigte Verbindung und die Photoinitiatoren zu der Zusammensetzung zugegeben. Wenn zusätzliche Verdünnungsmittel zur Herabsetzung der Viskosität der Zusammensetzung zugegeben werden sollen, können diese im allgemeinen in diesem Stadium zugegeben werden.

Anschließend wird die Zusammensetzung auf die gewünschte Unterlage in der gewünschten Schichtdicke aufgetragen. Im allgemeinen sind nicht mehr als etwa 0,254 mm, vorzugsweise nicht mehr als etwa 0,127 mm ausreichend für die Herstellung gedruckter Schaltkreisplatten, wobei etwa 0,051 mm einen noch geeigneten Minimalwert darstellen. Der Photoresist kann auf einen Trägerfilm oder auf die gewünschte Schaltplatte je nach dem danach anzuwendenden Verfahren aufgetragen werden.

Die Trägerfilme müssen von der Zusammensetzung entfernt werden können, ohne daß die Integrität des Films zerstört wird, und sie sollten flexibel genug sein, daß sie aufgewickelt werden können. Geeignete Trägerfilme schließen solche aus Polyestern, wie Polyäthylenterephthalat ein.

Der Film wird dann mit ultravioletter Strahlung durch eine bildtragende Transparenz des gewünschten Musters belichtet. Durch die Belichtung mit ultraviolettem Licht wird die Polymerzusammensetzung vernetzt, wodurch sie unlöslich wird. Nach dem Belichten mit ultraviolettem Licht und nach dem Entfernen des Trägerfilms, falls ein solcher verwendet wird, wird der Überzug entwickelt, indem die nicht mit ultraviolettem Licht belichteten Bereiche entfernt werden. Dies kann durch Tauchen oder Besprühen des Films mit einem geeigneten Lösungsmittel geschehen. Als Lösungsmittel wird ein solches ausgewählt, welches die nichtgehärtete Polymerzusammensetzung löst, ohne in unerwünscht hohem Maße die gehärtete Zusammensetzung anzugreifen.

Butyldiglykolacetat und Butyldiglykol sind für die Durchführung der Erfindung geeignete Lösungsmittel. Wie bereits zuvor angegeben, besteht ein Vorteil der Erfindung darin, daß ein anderes Lösungsmittel als Trichloräthylen, welches krebserzeugend sein kann, zur Entwicklung angewendet werden kann.

Wenn es gewünscht wird, kann der Film nachgehärtet werden, indem er etwa eine halbe bis zehn Stunden lang erhöhten Temperaturen von etwa 100 bis 160°C ausgesetzt wird. Die angegewendeten Nachhärtzeiten können niedriger sein als diejenigen, die für die Zusammensetzungen gemäß der deutschen Patentschrift 24 59 179 angewendet werden, wobei gleichzeitig härtere Filme als die in dieser Patentschrift beschriebenen, erhalten werden.

Es können auch Zusatzmittel, die üblicherweise in der Epoxidharztechnologie verwendet werden, in der strahlungsempfindlichen Überzügen gemäß der Erfindung verwendet werden. Zusätze, die drastisch die Lichtabsorption des Überzugs herabsetzen oder den Photoresist nachteilig beeinflussen, müssen vermieden werden. Wenn Zusätze verwendet werden, sollten diese nach Erhalt des Vorreaktionsprodukts der Säure und des Epoxidharzes zugesetzt werden, um irgendwelche nachteiligen Einflüsse auf die Reaktionsmechanismen zu vermeiden.

Unterlagen, auf die die strahlungsempfindlichen Überzüge normalerweise aufgetragen werden, können aus Metall, Kunststoff, Glas oder jedem anderen Material bestehen, auf das Epoxidharze normalerweise aufgetragen werden. Der Spektralbereich der Belichtung, die Zeit und die Intensität für einen typischen strahlungsempfindlichen Überzug sind aus den nachfolgenden Bedingungen ersichtlich: Belichtung des Überzugs in einem Abstand von 76,2 cm mit einer Kohlebogenlampe, hergestellt von Nu-Ark Company, Inc., Chicago, Illinois, mit 15,5 Ampere; Dauer der Belichtung etwa 1 bis 10 Minuten. Da die Filme, die erfindungsgemäß hergestellt werden, visuell klar sind, hat die Filmdicke, wenn überhaupt, einen sher geringen Einfluß auf die benötigte Belichtungszeit.

## Beispiel 1

Zu einer 50 %igen Lösung, die etwa 197 Gewichtsteile eines oktafunktionellen Epoxidharzes (Warenzeichen EPI—REZ SU8) mit einem Epoxidäquivalentgewicht von etwa 197 und etwa 197 Gewichtsteile Trichloräthylen enthält, wurden 72,06 Gewichtsteile Acrylsäure und etwa 1,7 Gewichtsteile Benzyldimethylamin als Promoter zugegeben. Man läßt die Mischung etwa 64 Stunden lang bei etwa 65°C reagieren. Etwa 100 Teile der zuvor angegebenen Zusammensetzung werden mit etwa 2 Gewichtsteilen Trimethylolpropan-triacrylat, etwa 2 Gewichtsteilen tert-Butylanthrachinon, etwa 0,1 Gewichtsteilen Benztriazol, etwa 24 Gewichtsteilen Trichloräthylen und etwa 4 Gewichtsteilen Methyläthylketon gemischt.

Die Zusammensetzung wird auf eine Seite einer 141,75 Gramm schweren Kupferunterlage mittels Verspinnen zu einer Schichtdicke von etwa 0,051—0,064—0,076 mm aufgetragen und 2 Stunden lang bei 60°C getrocknet. Der Uberzug wird durch einen Stufenkeil mit einer 15,5 Ampere Kohlebogenlampe aus einer Entfernung von 50,8 cm belichtet. Belichtungszeiten von etwa 3 Minuten sind mehr als ausreichend zur Herstellung eines annehmbaren Bildes nach der Entwicklung. Die Zusammensetzung wird entwickelt, indem man das Bild mit Butyldiglykolacetat in Kontakt bringt.

Mit der zuvor beschriebenen Überzugsmasse werden ausgezeichnete Bilder mit scharfen Kanten und hervorragender Auflösung erhalten. Die Ergebnisse waren reproduzierbar bei Anwendung verschiedener Lote der oben beschriebenen Epoxidpolymeren. Mit der erfindungsgemäßen Überzugszusammensetzung bleibt mehr als 90% der ursprünglichen Schichtdicke erhalten im Vergleich zu etwa 45% bei Verwendung bisher bekannter Zusammensetzungen (deutsche Patentschrift 24 59 179). Demzufolge wird das Problem des übermäßigen Schichtdickenverlustes durch die vorliegende Erfindung vermieden.

## Beispiel 2

Zu einer 50 %igen Lösung mit einem Gehalt an 220 Gewichtsteilen eines oktafunktionellen Epoxidharzes (Warenzeichen Epi-Rez SU—8) mit einem Epoxidäquivalentgewicht von etwa 220 und etwa 220 Gewichtsteilen Trichloräthylen wurden etwa 72,06 Gewichtsteile Acrylsäure und etwa 2,2 Gewichtsteile Benzyldimethylamin als Promotor zugegeben. Man ließ die Mischung bei etwa 65°C reagieren, bis die Viskosität einen Werte von $1{,}8 \times 10^{-3} \pm 0{,}2 \times 10^{-3}$ m²/s erreichte, was nach etwa 48 Stunden der Fall war.

Etwa 100 Teile der zuvor angegebenen Zusammensetzung wurden mit etwa 50 Gewichtsteilen Äthylenglykol-monomethyläther, etwa 2 Gewichtsteilen tert-Butylanthrachinon, etwa 2 Gewichtsteilen Trimethylolpropan-triacrylat, etwa 1 Teil 2-Phenylimidazol und etwa 0,05 Teilen Benztriazol gemischt.

Die Zusammensetzung wird auf eine Seite eines mit Kupfer laminierten Substrats in einer mittleren Schichtdicke von etwa 0,064 mm aufgesprüht und 2 Stunden lang bei etwa 60°C getrocknet. Der Überzug wird durch einen Stufenkeil mit einer 15,5 Ampere Kohlebogenlampe aus einer Entfernung von 50,8 cm belichtet. Belichtungszeiten von etwa 3 Minuten sind mehr als ausreichend zur Herstellung eines brauchbaren Bildes nach der Entwicklung. Die Zusammensetzung wird entwickelt, indem sie mit Butyldiglykol in Berührung gebracht wird.

Mit dem zuvor beschriebenen Überzug wurden ausgezeichnete Bilder mit scharfen Kanten und hervorragender Auflösung erhalten. Mit dieser Zusammensetzung konnte keine Zackenbildung beobachtet werden. Mehr als 90% der ursprünglichen Schichtdicke blieben nach der Entwicklung erhalten.

## Patentansprüche

1. Strahlungsempfindliche Überzugszusammensetzung mit einem Gehalt an einer polyäthylenisch ungesättigten Verbindung, einem Photoinitiator, gegebenenfalls einem Härtungsmittel und einem Verdünnungsmittel, dadurch gekennzeichnet, daß sie ein Reaktionsprodukt aus
   (1) wenigstens einem epoxidierten nichtlinearen Novolak mit mindestens 6 endständigen Epoxidgruppen und
   (2) wenigstens 0,9 Mol mindestens einer monoäthylenisch ungesättigten Carbonsäure pro Epoxidäquivalentgewicht des Novolaks enthält.

2. Überzugszusammensetzung nach Anspruch 1, dadurch gekennzeichnet, daß der Novolak nachfolgend angegebene allgemeine Formel mit 8 endständigen Epoxidgruppen aufweist:

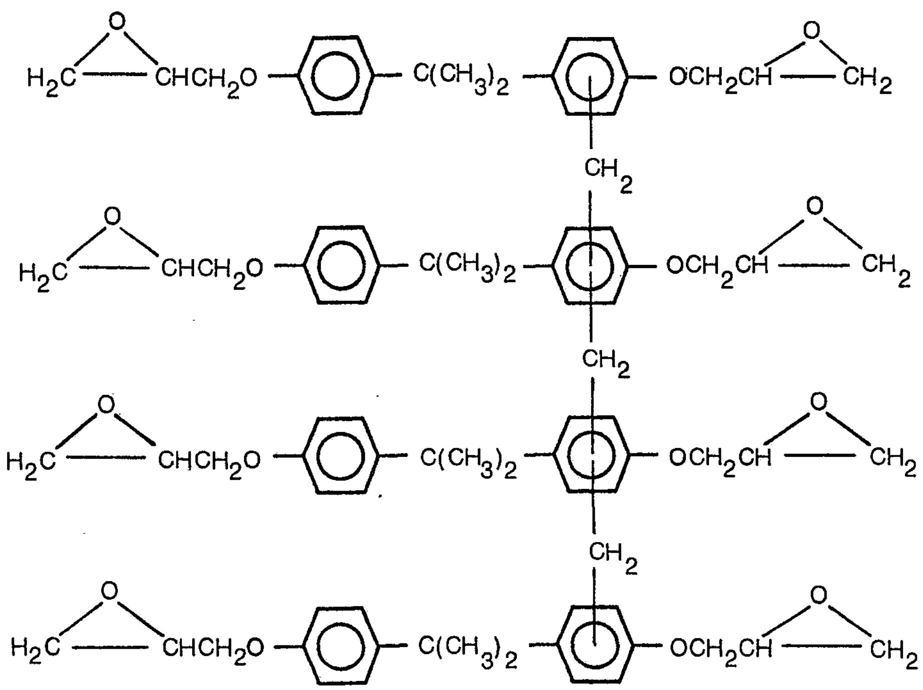

3. Überzugszusammensetzung nach den Ansprüchen 1 und 2, dadurch gekennzeichnet, daß sie 0,9 bis 2 Mol, vorzugsweise 1 bis 1,2 Mol Acrylsäure, Methacrylsäure, Crotonsäure und Mischungen derselben pro Epoxidäquivalentengewicht des epoxidierten Novolaks an den Novolak gebunden enthält.

4. Überzugszusammensetzung nach Anspruch 1, dadurch gekennzeichnet, daß sie als polyäthylenisch ungesättigte Verbindung Trimethylolpropan-triacrylat oder Polyäthylenglykol-diacrylat enthält.

5. Überzugszusammensetzung nach den Ansprüchen 1 und 4, dadurch gekennzeichnet, daß sie die Polyäthylenisch ungesättigte Verbindung in einer Menge von 0,5 bis 40 Gew.%, vorzugsweise 1 bis 20 Gew.% enthält.

6. Überzugszusammensetzung nach Anspruch 6, dadurch gekennzeichnet, daß sie die polyäthylenisch ungesättigte Verbindung in einer Menge von 3 Gew.% enthält.

7. Überzugszusammensetzung nach Anspruch 1, dadurch gekennzeichnet, daß sie als Photoinitiator tert-Butylanthrachinon und Benztriazol enthält.

8. Überzugszusammensetzung nach den Ansprüchen 1 und 7, dadurch gekennzeichnet, daß sie den Photoinitiator in einer Menge von 0,1 bis 10 Gew.%, vorzugsweise 0,1 bis 5 Gew.% enthält.

9. Überzugszusammensetzung nach Anspruch 1, dadurch gekennzeichnet, daß sie als zusätzliches Härtungsmittel Phenylimidazol enthält.

10. Überzugszusammensetzung nach Anspruch 1, dadurch gekennzeichnet, daß sie zusätzlich ein

Verdünnungsmittel enthält, das in einer solchen Menge angewendet wird, daß Zusammensetzungen mit einer Viskosität zwischen $3 \times 10^{-5}$ und $2{,}5 \times 10^{-3}$ $m^2/s$ erhalten werden.

11. Verwendung der Uberzugszusammensetzung nach den Ansprüchen 1 bis 10 zur Herstellung eines negativen Resistbilds, das als Schutzüberzug auf integrierten Schaltkreisplatten verbleibt.

**Revendications**

1. Composition de revêtement sensible aux radiations contenant un composé à polyéthylène non saturé, un photo-initiateur, et éventuellement un agent de durcissement et un diluant, caractérisée en ce qu'elle comporte un produite de réaction composé:

(1) d'au moins un novolac non linéaire époxydé contenant au moins six groups d'époxy terminaux, et

(2) d'au moins 0,9 moles d'au moins un acide carboxylique monoéthylène non saturé, par poids équivalent d'époxy du novolac.

2. Composition de revêtement selon la revendication 1, caractérisée en ce que le novolac présente la formule générale comportant huit groupes d'époxy terminaux:

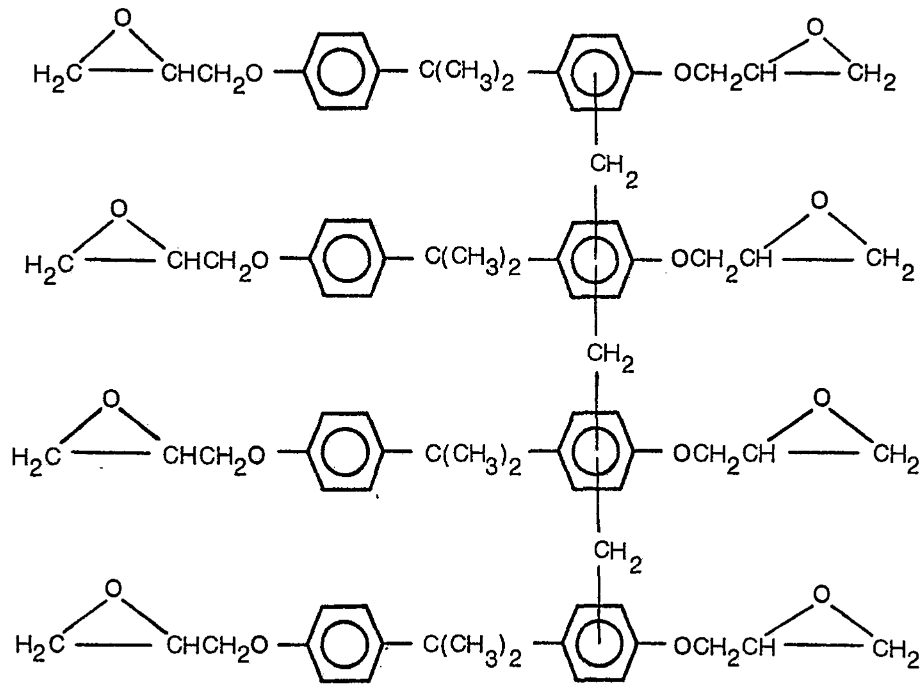

3. Composition de revêtement selon les revendications 1 et 2, caractérisée en ce qu'elle contient de 0,9 à 2 moles, de préférence de 1 à 1,2 moles, d'acide acrylique, d'acide méthacrylique, d'acide crotonique et de mélanges de ceux-ci par poids équivalent d'époxy du novolac époxydé,chimiquement lié au novolac.

4. Composition de revêtement selon la revendication 1, caractérisée en ce qu'elle contient du triméthylol propane-triacrylate ou du polyéthylène glycol diacrylate comme composé polyéthylène non saturé.

5. Composition de revêtement selon les revendications 1 et 4, caractérisée en ce qu'elle contient un composé polyéthylène non saturé dans une quantité allant de 0,5 à 40% en poids, de préférence de 1 à 20% en poids.

6. Composition de revêtement selon la revendication 6, caractérisée en ce qu'elle contient un composé polyéthylène non saturé dans une quantité de 3% en poids.

7. Composition de revêtement selon la revendication 1, caractérisée en ce qu'elle contient du tert-butylanthraquinone et du benzotriazole comme photo-initiateur.

8. Composition de revêtement selon les revendications 1 et 7, caractérisée en ce qu'elle contient le photo-initiateur dans une quantité allant de 0,1 à 10% en poids, de préférence, de 0,1 à 5% en poids.

9. Composition de revêtement selon la revendication 1, caractérisée en ce qu'elle contient du phényl imidazole comme agent de durcissement supplémentaire.

10. Composition de revêtement selon la revendication 1, caractérisée en ce qu'elle contient en plus un diluant utilisé dans une quantité qui permet d'obtenir des compositions ayant une viscocité comprise entre $3 \times 10^{-5}$ et $2{,}5 \times 10^{-3}$ $m^2/s$.

11. Utilisation de la composition de revêtement selon l'une quelconque des revendications 1 à 10, pour fabriquer une image photorésistante négative qui reste comme revêtement protecteur sur des panneaux à circuits intégrés.

## Claims

1. Radiation-sensitive coating composition containing a polyethylenically unsaturated compound, a photoinitiator, possibly a hardening agent and a diluent, characterized in that it contains a reaction product of
(1) at least one epoxidized nonlinear novolac with at least 6 terminal epoxy groups, and
(2) at least 0.9 moles of at least one monoethylenically unsaturated carboxylic acid per epoxide equivalent weight of the novolac.

2. Coating composition as claimed in claim 1, characterized in that the novolac has the following general formula with 8 terminal epoxy groups:

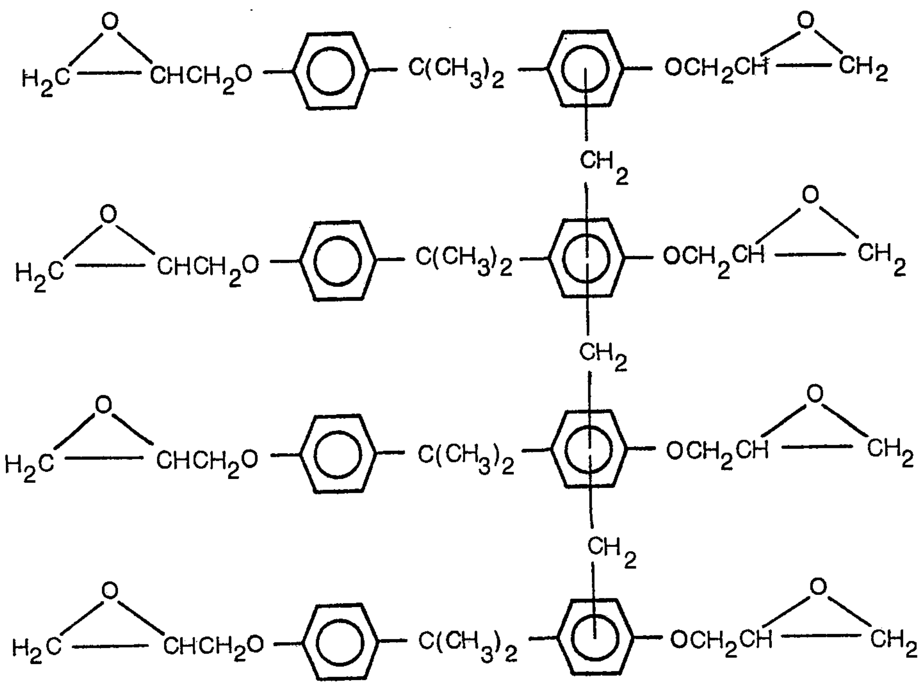

3. Coating composition as claimed in claims 1 and 2, characterized in that it contains 0.9 to 2 moles, preferably 1 to 1.2 moles acrylic acid, methacrylic acid, crotonic acid, and mixtures thereof per epoxide equivalent weight of the epoxidized novolac chemically bonded to the novolac.

4. Coating composition as claimed in claim 1, characterized in that as polyethylenically unsaturated compound is contains trimethylol propane triacrylate or polyethylene glycol diacrylate.

5. Coating composition as claimed in claims 1 and 4, characterized in that it contains the polyethylenically unsaturated compound in a quantity of 0.5 to 40% by weight, preferably 1 to 20% by weight.

6. Coating composition as claimed in claim 6, characterized in that it contains the polyethylenically unsaturated compound in a quantity of 3% by weight.

7. Coating composition as claimed in claim 1, characterized in that it contains as a photoinitiator tert-butyl anthraquinone and benzotriazole.

8. Coating composition as claimed in claims 1 and 7, characterized in that it contains the photoinitiator in a quantity of 0.1 to 10% by weight, preferably 0,1 to 5% by weight.

9. Coating composition as claimed in claim 1, characterized in that it contains as an additional hardening agent phenyl imidazole.

10. Coating composition as claimed in claim 1, characterized in that it additionally contains a diluent which is used in such a quantity that compositions having a viscosity between $3 \times 10^{-5}$ and $2.5 \times 10^{-3}$ $m^2/s$ are obtained.

11. Use of the coating composition as claimed in any one of claims 1 to 10 to make a negative resist image which remains as a protective coating on integrated circuit boards.